# EUROPEAN PATENT APPLICATION

(11) **EP 4 709 086 A1**
(43) Date of publication of application: **11.03.2026**
(21) Application number: 25199012.3
(22) Date of filing: 29.08.2025
(51) Int. Cl.: H10D 64/66, H10D 30/66, H10D 62/832, H10D 30/01

(54) **MANUFACTURING PROCESS FOR SILICON CARBIDE POWER ELECTRONIC DEVICES HAVING AN IMPROVED INPUT CAPACITANCE DEFINITION OF THE SAME**

(30) Priority: 10.09.2024 IT 202400020143
(71) Applicant: STMicroelectronics International N.V., 1228 Plan-les-Ouates, Geneva (CH)
(72) Inventor: SAGGIO, Mario Giuseppe, 95020 ACI BONACCORSI (CT) (IT); CAMALLERI, Cateno Marco, 95125 CATANIA (IT); SCALIA, Laura Letizia, 95037 SAN GIOVANNI LA PUNTA (CT) (IT); GUARNERA, Alfio, 95039 TRECASTAGNI (CT) (IT); ZANETTI, Edoardo, 95028 VALVERDE (CT) (IT); SCUDERI, Valentina, 95127 CATANIA (IT)
(74) Representative: Studio Torta S.p.A.

(57) **Abstract**

A process for manufacturing a vertically conducting power device (1) includes: in a body (2), containing semiconductor material and having a first electrical conductivity, forming body regions (5), having a second electrical conductivity opposite to the first electrical conductivity; forming, in respective body regions (5), source regions (7), having the first electrical conductivity; forming gate structures (4) each comprising an insulating gate region (41) on the body (2), a conductive gate region (42) on the insulating gate region (41), and a passivation gate region (43) on the conductive gate region (42), wherein the conductive gate region (42) is partially overlapped on the source regions (7) of respective adjacent body regions (5); and forming a source metallization region (6) on the body (2) and on the gate structures (4) comprising contact portions (61) with respective source regions (7) between adjacent gate structures (4). Forming the contact portions (61) comprises: forming, in a conformal manner, a spacer dielectric layer (144) on the gate structures (4) and on the body (2); and etching the spacer dielectric layer (144) anisotropically up to the source regions (7).

## Description

### Technical Field

The present invention relates to a manufacturing process for silicon carbide power electronic devices having an improved input capacitance definition of the same.

### Background

As is known, semiconductor materials having a wide bandgap, for example greater than 1.1 eV, low on-state resistance, high thermal conductivity, high operating frequency and high saturation velocity of charge carriers allow to obtain electronic devices, such as diodes and transistors, having better performance than silicon electronic devices, in particular for power applications (i.e. for operating voltages for example comprised between 600 V and 1300 V, or in specific operating conditions such as high temperature).

In detail, it is known to obtain such electronic devices starting from a wafer of silicon carbide (SiC) in one of its polytypes, for example 3C-SiC, 4H-SiC and 6H-SiC, which are distinguished by the characteristics listed above. The power electronic devices obtainable by using SiC-type semiconductors may be, for example, vertically conducting MOSFET or JFET transistors.

In a MOSFET device, the input capacitance is mainly defined by the sum of the capacitance between gate and source terminals (also called "gate-source capacitance") of the device and the capacitance between gate and drain terminals (also called "gate-drain capacitance") of the device. The input capacitance defines the dynamic behavior of the device and influences its efficiency in the specific application. The value of the input capacitance obtainable for a given device is mainly defined by the structure of the elementary cells and the on-board structures of the device.

MOSFET devices for high-power applications, especially SiC-technology power devices, such as for example power inverters, comprise a plurality of elementary cells, which are typically assembled in parallel to reduce the on-resistance of each inverter stage. Such a configuration may cause ringing effects in the gate-source and drain-source waveforms during the switching phases (especially at power up) of the device, mainly due to gate-source coupling phenomena.

In order to prevent oscillations in parallel configurations of MOSFET devices, a series of capacitances may be inserted in parallel to the gate-source capacitance and/or to the gate-drain capacitance of the device with the aim of increasing its input capacitance (for example, one or more discrete capacitors mounted on the electronic board of the specific application). However, the introduction of such discrete capacitors may entail several drawbacks, such as higher production costs, loss of efficiency and greater complexity in the management of the driving circuits.

### Summary

It is therefore an aim of the present invention to overcome or at least partly mitigate the disadvantages and limitations of the state of the art.

According to the present invention, a manufacturing process for silicon carbide power electronic devices is provided as defined in the attached claims.

### Brief Description of the Figures

For a better understanding of the present invention, preferred embodiments are provided, by way of non-limiting example, with reference to the attached drawings, wherein:
- Figure 1 schematically shows a cross-section through a power device in accordance with an embodiment of the present invention;
- Figures 2A-2E schematically show a cross-section of the power device of Figure 1 in successive manufacturing steps of a manufacturing process in accordance with an embodiment of the present invention; and
- Figure 3 is a simplified block diagram relating to the process of Figures 2A-2E.

### Description of Embodiments

The following description refers to the arrangement shown in the drawings; consequently, expressions such as "above", "below", "upper", "lower", "top", "bottom", "right", "left" and the like, relate to the attached Figures and are not to be interpreted in a limiting manner.

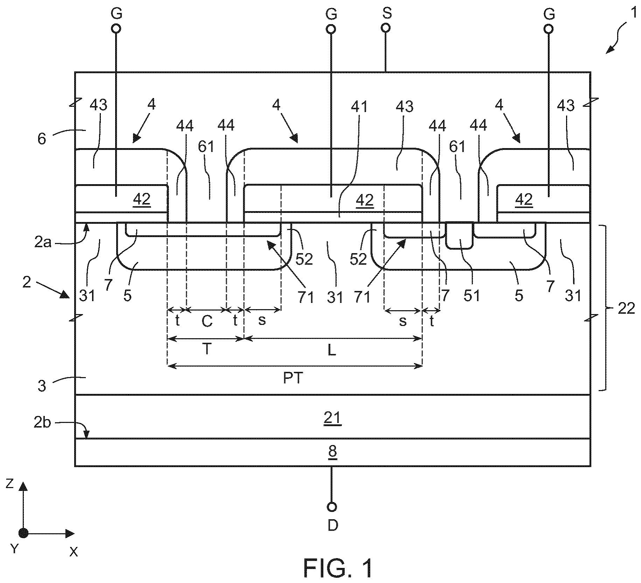

A power device manufactured in accordance with an embodiment of the present invention is illustratedin a part thereof in Figure 1 and is indicated by the numeral 1. The power device 1 is for example a MOSFET - in particular a power MOSFET, even more in particular a vertically conducting MOSFET made in silicon carbide (SiC) technology - and is accommodated in a die not shown in the attached Figures. Hereinafter, therefore, the power device 1 is also referred to as "MOSFET" interchangeably and without any loss of generality.

Figure 1 shows, in a cross-section thereof, the MOSFET 1 in a reference system of orthogonal axes X, Y, Z.

The MOSFET 1 comprises a plurality of elementary cells
- of which only one is shown in the attached Figures - equal to each other and arranged in the same die so as to share a drain terminal D, a gate terminal G and a source terminal S; i.e., the elementary cells are electrically connected in parallel to each other.

The MOSFET 1 is formed in a body 2 of semiconductor material. The body 2 is delimited at the top by a front side 2a and at the bottom by a back side 2b, opposite to each other along the direction of the Z axis. The body 2 may comprise a substrate or a substrate having one or more epitaxial layers grown thereon and is of silicon carbide, in one of its polytypes, for example the 4H-SiC polytype. In one embodiment, in particular, the body 2 comprises a substrate 21, which is delimited at the bottom by the back side 2b, and an epitaxial layer 22 that extends on the substrate 21 and is delimited at the top by the front side 2a.

A drift region 3, a plurality of body regions 5 (two shown in Figure 1) and a plurality of source regions 7 (two shown in Figure 1) are formed in the epitaxial layer 22. The body 2 of semiconductor material, i.e. the substrate 21 and the drift region 3, and the source regions 7 have a first electrical conductivity, for example of the N-type. The body regions 5 have a second electrical conductivity, of the P-type, opposite to the first electrical conductivity. Each body region 5 has a doping level comprised for example between 1·10¹⁷ atoms/cm³ and 1·10²⁰ atoms/cm³; each source region 7 has a doping level comprised for example between 1·10¹⁸ atoms/cm³ and 1·10²⁰ atoms/cm³.

The body regions 5 extend into the body 2 starting from the front side 2a and are separated from each other along the X axis by surface portions 31 of the drift region 3. Each source region 7 extends into the body 2 starting from the front side 2a and is embedded in a respective body region 5. Each elementary cell of the MOSFET 1 comprises at least one body contact region 51, having the second electrical conductivity and extending from the front side 2a up to one of the body regions 5 through the respective source region 7. Channel regions 52 are defined in the body regions 5 between the respective source regions 7 and surface portions 31 of the drift region 3.

The body regions 5, the source regions 7 and the body contact regions 51 also extend along the Y axis, having, in a top view (not shown here), for example, the shape of strips or rings.

In the epitaxial layer 22 of the MOSFET 1, in use, i.e. when the voltage between the gate terminal G and the source terminal S (V_{GS}) is greater than a threshold voltage (V_{TH}) of the elementary cell, a current may flow between the source terminal S and the drain terminal D, through each channel region 52 and the drift region 3. The drift region 3 in fact forms, in use, the drift layer of the charge carriers.

The MOSFET 1 also comprises a plurality of gate structures 4 arranged above the front side 2a of the body 2. The gate structures 4 each comprise: an insulating gate region 41 (e.g., silicon oxide), in contact with the front side 2a of the body 2; a conductive gate region 42 (e.g., of polysilicon), directly overlapped on the insulating gate region 41; and a passivation gate region 43 (e.g., an oxide), which covers the conductive gate region 42 and, together with the insulating gate region 41, seals the conductive gate region 42. The conductive gate regions 42 of the gate structures 4 are electrically connected in parallel, in a manner not shown here, forming the gate terminal G of the MOSFET 1. In one embodiment, in particular, for each gate structure 4, the width (along the X axis) of the conductive gate region 42 - hereinafter referred to as the gate strip width L - substantially coincides with the width (along the X axis) of the insulating gate region 41.

The conductive gate region 42 of each gate structure 4 extends between the source regions 7 of a pair of adjacent body regions 5. In detail, the conductive gate region 42 is partially overlapped on the source regions 7 of the two adjacent body regions 5 and extends on the channel regions 52 and on the surface portion 31 of the drift region 3 comprised between the source regions 7. In more detail, with reference to the single elementary cell shown in Figure 1, the projection (along the Z axis) of the conductive gate region 42 on the underlying and respective source regions 7 defines respective overlap regions 71 having a dimension, along the X axis, hereinafter referred to as overlap width s. The gate strip width L is greater than the overlap width s. Furthermore, the gate strip width L is as a first approximation equal to the sum of: twice the overlap width s, twice the width of respective channel regions 52, and the width of the surface portion 31 of the drift region 3.

The MOSFET 1 also comprises a source metallization region 6, for example of metal material and/or metal silicide, which forms the source terminal S of the MOSFET 1 and extends on the front side 2a of the body 2, in direct electrical contact with the source regions 7 and the body contact regions 51. The body contact regions 51 are in fact used to bias, at the electrical potential of the source terminal S, the body regions 5.

Adjacent gate structures 4 in the MOSFET 1 are separated by respective contact portions 61 of the source metallization region 6. More in particular, each contact portion 61 of the source metallization region 6 is interposed, in contact, between the passivation gate regions 43 of two adjacent gate structures 4. Furthermore, the contact portions 61 form an electrical contact with corresponding source regions 7 and body contact regions 51. Hereinafter the width along the X axis of each contact portion 61 at the interface with the respective source region 7 is referred to as the contact width C and is intended to be measured, in proximity to the front side 2a of the body 2, between the respective passivation gate regions 43 of two adjacent gate structures 4.

As anticipated, the passivation gate region 43 of each gate structure 4 coats, at the top and laterally, the corresponding conductive gate region 42. More in particular, the passivation gate regions 43 comprise spacer portions 44 that extend on the sides of the respective insulating gate regions 41 and conductive gate regions 42 and delimit respective contact portions 61 in the direction of the X axis. In other words, the spacer portions 44 are arranged on opposite sides (along the X axis) of the conductive gate region 42 of the gate structure 4. As explained below, the spacer portions 44 may be of a different material (e.g., a different type of oxide) with respect to the corresponding passivation gate region 43. The width along the X axis of each spacer portion 44 is hereinafter referred to as the spacer width t and is intended to be measured in proximity to the front side 2a of the body 2.

In MOSFET 1 therefore, the conductive gate regions 42 belonging to adjacent gate structures 4 are separated by a gate strip distance T which is equal to the sum of: a spacer width t (referred to a spacer portion 44 of a gate structure 4), the contact width C of the interposed contact portion 61, and a spacer width t (referred to a spacer portion 44 of the other gate structure 4). Even more in particular, the sum of the gate strip width L and the gate strip distance T defines the pitch PT of the MOSFET 1, which, in current devices, is greater than 4um. The pitch PT is indicative of the dimension (along the X axis) of the elementary cell of the MOSFET 1.

The MOSFET 1 finally comprises a drain metallization region 8, of conductive material for example of metal or silicide, which extends on the back side 2b of the body 2 (in the opposite direction to the source metallization region 6), in direct electrical contact with the substrate 21, and forms the drain terminal D of the MOSFET 1.

The capacitance between the gate terminal G and the source terminal S (also called "gate-source capacitance", C_{GS}) of the MOSFET 1 is determined by the overlap width s of the overlap region 71 between the conductive gate region 42 and respective source regions 7. In more detail, the overlap width s is selected according to design preferences so as to define in an accurate and flexible manner an input capacitance (C_{IN}) of the MOSFET 1, in relation to desired target parameters and/or desired applications of use. In MOSFET 1, the value of gate-source capacitance C_{GS} is higher the larger the overlap width s. The capacitance between the gate terminal G and the drain terminal D (also called "gate-drain capacitance") is instead independent of the overlap width s. Furthermore, the overlap width s is selected without modifying the pitch PT of the MOSFET 1, and more in particular without modifying the contact width C of the contact portion 61 of the source metallization region 6, as explained below, and for a given width (along the X axis) of the source regions 7. In MOSFET 1, a reliable control of the dynamic behavior of the device may be obtained, through an accurate definition of the input capacitance, preventing unwanted phenomena such as oscillations during the switching phases.

In practice, in order to vary the overlap width s with respect to conventional devices without modifying the pitch PT of the MOSFET 1 and the contact width C of the contact portion 61 of the source metallization region 6, the invention allows to vary, according to design preferences, the gate strip distance T between conductive gate regions 42 belonging to adjacent gate structures 4. More in particular, in order to increase the value of gate-source capacitance C_{GS}, the gate strip width L of the conductive gate regions 42, given the pitch PT of the MOSFET 1, may be increased, consequently increasing the overlap width s. As a result, in MOSFET 1, the overlap width s is varied by varying, in an inversely proportional manner, the spacer width t of the spacer portions 44 of respective passivation gate regions 43; consequently, when the overlap width s is maximized, the spacer width t is correspondingly minimized, with the same contact width C of the contact portion 61.

In more detail, the gate-source capacitance C_{GS} and, ultimately, the input capacitance C_{IN} of the MOSFET 1, is correlated to the difference between the pitch PT and the gate strip distance T between conductive gate regions 42 belonging to adjacent gate structures 4. If the gate strip distance T, at the limit, tends to zero, a maximum limit value C_{IN}^{T} of the input capacitance C_{IN} is obtained. By selecting corresponding values of the overlap width s of the overlap region 71, the input capacitance C_{IN} may be selected between an effective minimum value C_{IN}^{MIN} and an effective maximum value C_{IN}^{MAX}.

Correspondingly, the values of the input capacitance C_{IN} of the MOSFET 1 are obtained as a function of the ratio between the gate strip distance T and the pitch PT of the MOSFET 1, a ratio that assumes, for the MOSFET 1, values comprised between 0.4 and 0.9. In particular, the values of C_{IN}^{MIN} and C_{IN}^{MAX} are given by:

C_{IN}^{MIN} = 40%·C_{IN}^{T}, and C_{IN}^{MAX} = 90%·C_{IN}^{T}.

The Applicant has verified that, for the MOSFET 1, effective maximum values of input capacitance C_{IN} may be obtained that are 20% greater than a MOSFET that has the same contact width C as the contact portion 61 of the source metallization region 6.

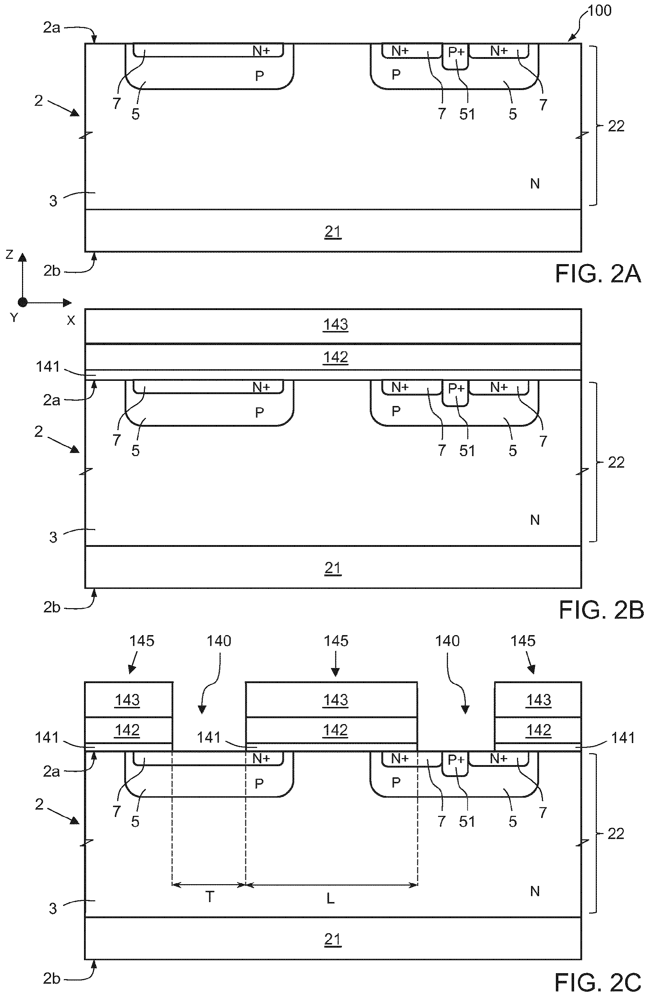

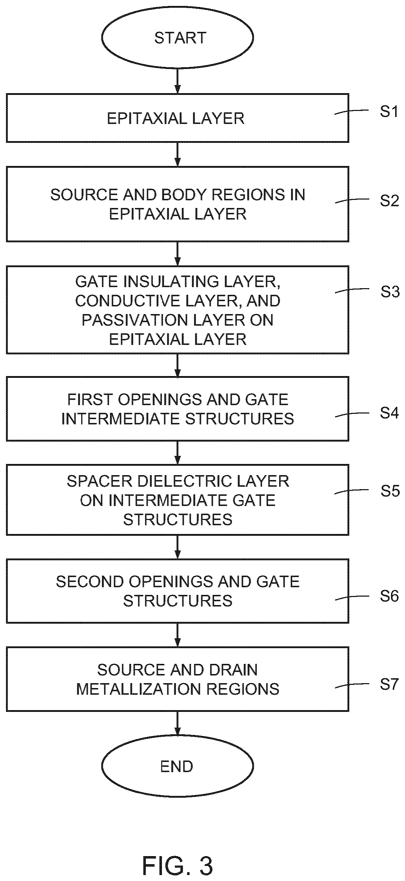

The MOSFET 1 of Figure 1 may be obtained by means of the manufacturing process described below with reference to Figures 2A-2E and schematically to the flow chart of Figure 3.

Figure 2A shows a cross-section of a wafer 100 of silicon carbide (e.g., of the 4H-SiC polytype), here having the first electrical conductivity (N-type). The wafer 100 is delimited at the top by the front side 2a and at the bottom by the back side 2b and initially comprises the substrate 21, on which the epitaxial layer 22 is formed by epitaxial growth (first step S1), for example with a thickness along the Z axis comprised between 1µm and 100µm.

The body regions 5, the body contact regions 51 and the source regions 7 are formed (second step S2) in the epitaxial layer 22 of the wafer 100, using specific masks (not shown) on the front side 2a. Each body region 5 extends, starting from the front side 2a, for a depth for example equal to 1µm and has a width (along the X axis) for example equal to 3um. Each source region 7 extends, starting from the front side 2a, within the respective body region 5, for a depth for example equal to 0.4µm and with a width (along the X axis) for example equal to 2.4um; the width of the source regions 7 is for example set according to design preferences with respect to the power performance of the MOSFET 1. Each body contact region 51 extends, starting from the front side 2a, within respective body regions 5, for a depth, for example equal to 0.4µm, greater than or equal to the depth of the source regions 7 and with a width (along the X axis) for example equal to 1µm. The source regions 7, of the N+ type, have a doping typically higher than the doping of the wafer 100. The body contact regions 51, of the P+ type, have a doping typically higher than the doping of the body regions 5.

The elementary cells of the MOSFET 1 (one shown in Figures 2A-2E) are thus completed. The drift region 3 is also thereby defined in a portion of the epitaxial layer 22 not occupied by the body regions 5. Ultimately, the entire body 2 of the MOSFET 1 is also completed.

Subsequently, Figure 2B, a gate insulating layer 141 (e.g., a silicon oxide), a gate conductive layer 142 (e.g., of polysilicon) and a gate passivation layer (or "intermediate dielectric layer") 143 are formed in succession on the body 2 (third step S3). In particular, the gate insulating layer 141 is formed on the front side 2a of the body 2, for example by oxidation processes of the body 2; the gate conductive layer 142 is formed on the gate insulating layer 141, for example by deposition or epitaxial reactor growth from a seed layer (not shown); and the gate passivation layer 143 is formed on the gate conductive layer 142, for example by deposition. The gate passivation layer 143 is formed by an intermediate dielectric, for example an oxide, an oxynitride, or a combination of oxides or nitrides with oxynitrides.

Successively, as shown in Figure 2C, the gate insulating layer 141, the gate conductive layer 142 and the gate passivation layer 143 are patterned by etching, using a mask not shown, in positions corresponding to the source regions 7, forming first openings 140 and corresponding intermediate gate structures 145 (fourth step S4). In particular, the first openings 140 extend (along the Z axis) up to the front side 2a of the body 2 and leave the source regions 7 and the body contact regions 51 at least partly exposed. Furthermore, the first openings 140 have an extension along the X axis corresponding to the gate strip distance T, which, as anticipated, is a design parameter with respect to the definition of the gate-source capacitance C_{GS} of the MOSFET 1. Consequently, the resulting intermediate gate structures 145 have a dimension along the X axis corresponding to the final gate strip width L of the conductive gate regions 42 of the MOSFET 1.

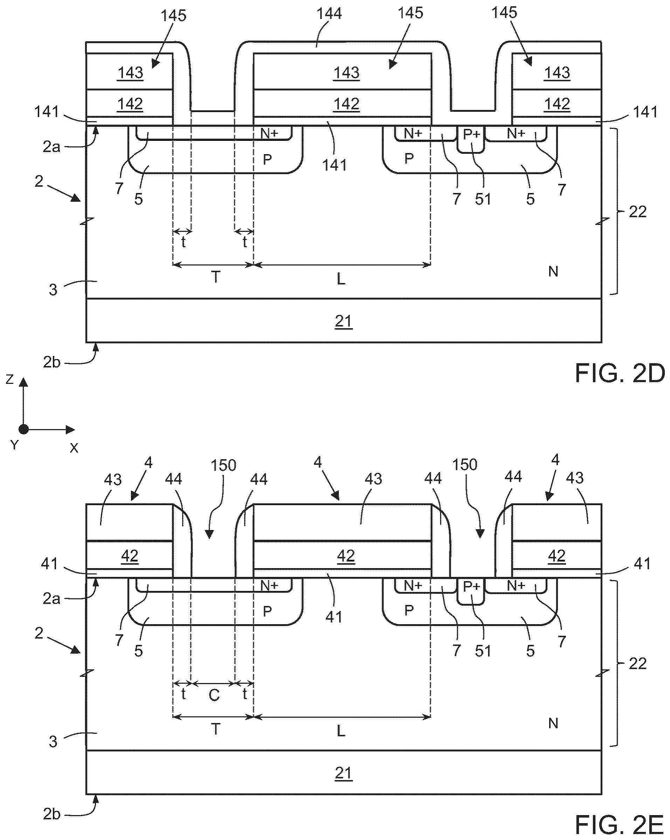

With reference to Figure 2D, a spacer dielectric layer 144 is then formed, in a conformal manner, on the body 2 and on the intermediate gate structures 145, for example by deposition (fifth step S5). In particular, the spacer dielectric layer 144 has a thickness substantially corresponding to the spacer width t and coats residual portions of the gate passivation layer 143, the front side 2a of the body 2 where exposed in the first openings 140 and laterally the sides of the intermediate gate structures 145. The gate conductive layer 142 of each preliminary gate structure 145 is therefore sealed. The spacer dielectric layer 144 is formed by a dielectric that may be different from the dielectric of the gate passivation layer 143, while still being compatible therewith in terms of adhesion; for example, the spacer dielectric layer 144 is formed by an oxide, or by an oxynitride, or by a combination of oxides or nitrides with oxynitrides. Furthermore, the spacer width t may have a minimum value, for example, equal to 0.2µm.

Subsequently, with reference to Figure 2E, a vertical etching, for example a time and/or selective etching, of the spacer dielectric layer 144 is performed. The vertical etching is for example an anisotropic etching, performed without the aid of a mask ("blanket etching"), for example in a CF₄ environment. Such etching completely removes portions of the spacer dielectric layer 144 parallel to the front side 2a of the body 2, forming second openings 150 (sixth step S6). Portions of the spacer dielectric layer 144 that cover the sides of the intermediate gate structures 145 remain substantially unchanged and form corresponding spacer portions 44. In more detail, the second openings 150 extend (along the Z axis) up to the front side 2a of the body 2 and leave the source regions 7 and the body contact regions 51 at least partly exposed. Furthermore, a dimension along the X axis of the second openings 150 defines the contact width C, previously described, and is determined according to design preferences by the dimension along the X axis of the first openings 140 and by the thickness of the spacer dielectric layer 144.

Finally (seventh step S7), a source metallization layer is formed, for example by deposition, which completely fills the second openings 150 and forms the source metallization region 6 of the MOSFET 1, and in particular the contact portions 61. The drain metallization region 8 is also formed on the back side 2b of the body 2, ultimately obtaining the MOSFET 1 of Figure 1.

The manufacturing process of the present invention therefore allows, compared to a photolithographic process performed with dedicated masks, to vary with greater freedom the gate strip distance T between the conductive gate regions 42 belonging to two adjacent gate structures 4, for a given contact width C of the contact portions 61 of the source metallization region 6. In particular, the spacer dielectric layer 144 allows to minimize the spacer width t, and therefore also the gate strip distance T, for the given contact width C. With the same pitch PT, therefore, the gate strip width L of the conductive gate regions 42 is greater and therefore also the overlap width s and the input capacitance C_{IN} of the MOSFET 1 are increased. More generally, the spacer width t of the spacer portions 44 may be selected as a function of the desired overlap width s of the overlap region 71 between the conductive gate regions 42 and respective source regions 7. Furthermore, the manufacturing process of the present invention allows to avoid the use of masks to pattern the contact portions 61 of the source metallization region 6, giving the MOSFET 1 an overall greater reliability.

Finally, it is clear that modifications and variations may be made to what has been described and illustrated herein without thereby departing from the scope of the present invention, as defined in the attached claims.

For example, in the source regions of the MOSFET the body contact regions may be absent.

The spacer portions of the gate structures may have a profile with sides arranged facing the contact portions of the source metallization region arranged obliquely with respect to the front side of the body, i.e. arranged with a different tilting from the perpendicular one shown.

In one embodiment not shown of the manufacturing process, the etching of Figure 2C that forms the first openings stops on the gate insulating layer and therefore the spacer portions of the gate structures obtained following the formation of the second openings (Figure 2E) comprise portions in proximity to the front side of the body formed by the same material as the gate insulating layer. In other words, in such an embodiment, the insulating gate regions of the gate structures have an extension along the X axis equal to the sum of the gate strip width L and twice the spacer width t.

In an alternative embodiment that has the same advantages previously described, the MOSFET further comprises: deep body regions, arranged below and in contact with respective body regions previously described; first Current Spreading Layer (CSL) regions, arranged below and in contact with respective deep body regions; and a second current spreading layer region, arranged in the drift region between two adjacent body regions and which extends, starting from the front side of the body, at least up to the first current spreading layer regions.

More generally, the MOSFET of the present invention may comprise body and source regions different from those described and shown in the shape and distribution of dopants. For example, some body regions may comprise portions having a higher dopant concentration than the average dopant concentration of the body regions.

## Claims

1. A process for manufacturing a vertically conducting power device (1) comprising
- in a body (2), containing semiconductor material and having a first electrical conductivity, forming body regions (5), having a second electrical conductivity opposite to the first electrical conductivity;
- forming, in respective body regions (5), source regions (7), having the first electrical conductivity;
- forming gate structures (4) each comprising an insulating gate region (41) on the body (2), a conductive gate region (42) on the insulating gate region (41), and a passivation gate region (43) on the conductive gate region (42), the conductive gate region (42) being partially overlapped on the source regions (7) of respective adjacent body regions (5); and
- forming a source metallization region (6) on the body (2) and on the gate structures (4), the source metallization region (6) comprising contact portions (61) with respective source regions (7) between adjacent gate structures (4), wherein forming the contact portions (61) comprises:
- forming, in a conformal manner, a spacer dielectric layer (144) on the gate structures (4) and on the body (2); and
- etching the spacer dielectric layer (144) anisotropically up to the source regions (7).

2. The process according to claim 1, wherein etching the spacer dielectric layer (144) comprises performing an unmasked etching.

3. The process according to claim 1 or 2, wherein the passivation gate region (43) of each gate structure (4) is formed by a first dielectric chosen from: an oxide, an oxynitride, or a combination of oxides or nitrides with oxynitrides.

4. The process according to any of the preceding claims, wherein the spacer dielectric layer (144) is formed by a second dielectric chosen from: an oxide, an oxynitride, or a combination of oxides or nitrides with oxynitrides.

5. The process according to any of the preceding claims, wherein the spacer dielectric layer (144) has a minimum thickness (t) equal to 0.2µm and laterally coats the gate structures (4).

6. The process according to any of the preceding claims, wherein forming the gate structures (4) comprises forming a gate conductive layer (142) and patterning the gate conductive layer (142) so that each resulting conductive gate region (42) is overlapped, along a first direction (Z), on respective source regions (7) in respective overlap regions (71), and
wherein conductive gate regions (42) of adjacent gate structures (4) are separated, along a second direction (X) perpendicular to the first direction (Z), by a distance (T), a ratio between the distance (T) and a pitch (PT) of the power device (1) assuming values comprised between 0.4 and 0.9.

7. The process according to any of the preceding claims, wherein etching the spacer dielectric layer (144) comprises defining a pair of spacer portions (44) on sides of each gate structure (4).

8. The process according to the preceding claim, wherein the spacer portions (44) seal the conductive gate region (42) of each gate structure (4).

9. The process according to any of the preceding claims, wherein the source regions (7) comprise respective body contact regions (51), wherein each body contact region (51) extends up to the respective body region (5).

10. The process according to any of the preceding claims, wherein the body (2) comprises a substrate (21) and an epitaxial layer (22), the body regions (5) and the source regions (7) being formed in the epitaxial layer (22), and wherein the semiconductor material contains silicon carbide.

11. The process according to the preceding claim, wherein the substrate (21) has a back side (2b) of the body (2), the process further comprising forming a drain metallization region (8) on the back side (2b).

12. A vertically conducting power device (1), comprising:
- a body (2), containing semiconductor material and having a first electrical conductivity;
- body regions (5), extending into the body (2) and having a second electrical conductivity opposite to the first electrical conductivity;
- source regions (7), extending into respective body regions (5) and having the first electrical conductivity;
- gate structures (4), each comprising an insulating gate region (41) on the body (2), a conductive gate region (42) on the insulating gate region (41), and a passivation gate region (43) on the conductive gate region (42), the conductive gate region (42) being partially overlapped along a first direction (Z) on the source regions (7) of respective adjacent body regions (5); and
- a source metallization region (6) on the body (2) and on the gate structures (4), the source metallization region (6) comprising contact portions (61) with respective source regions (7) between adjacent gate structures (4),
wherein each gate structure (4) laterally comprises spacer portions (44), in contact with the body (2) and delimiting respective contact portions (61).

13. The power device (1) according to claim 12, wherein each conductive gate region (42) is overlapped along the first direction (Z) on the respective source regions (7) in respective overlap regions (71), and
wherein conductive gate regions (42) of adjacent gate structures (4) are separated, along a second direction (X) perpendicular to the first direction (Z), by a distance (T), a ratio between the distance (T) and a pitch (PT) of the power device (1) assuming values comprised between 0.4 and 0.9.

14. The power device (1) according to claim 13, comprising a source terminal (S), electrically connected to the source metallization region (6), and a gate terminal (G), electrically connected to each conductive gate region (42) of the gate structures (4), the power device (1) having a capacitance (C_{GS}) between the gate terminal (G) and the source terminal (S) that depends on the ratio between the distance (T) and the pitch (PT) of the power device (1).

15. The power device (1) according to any of claims 12 to 14, wherein the semiconductor material contains silicon carbide.
